(19) **Europäisches Patentamt / European Patent Office / Office européen des brevets**

(11) **EP 3 229 282 B1**

(12) **FASCICULE DE BREVET EUROPEEN**

(45) Date de publication et mention
de la délivrance du brevet:
**17.02.2021 Bulletin 2021/07**

(51) Int Cl.:
***H01L 45/00*** *(2006.01)*

(21) Numéro de dépôt: **17164057.6**

(22) Date de dépôt: **31.03.2017**

(54) **MEMOIRE RESISTIVE, PROCEDES DE FABRICATION ET DE PROGRAMMATION ASSOCIES**

RESISTIVER SPEICHER, ENTSPRECHENDE HERSTELLUNGS- UND PROGRAMMIERUNGSVERFAHREN

RESISTIVE MEMORY, ASSOCIATED MANUFACTURING AND PROGRAMMING METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.04.2016 FR 1653138**

(43) Date de publication de la demande:
**11.10.2017 Bulletin 2017/41**

(73) Titulaire: **Commissariat à l'Energie Atomique et aux Energies Alternatives
75015 Paris (FR)**

(72) Inventeurs:
- **NAVARRO, Gabriele
  38000 Grenoble (FR)**
- **CHARPIN-NICOLLE, Christelle
  38120 Fontanil-Cornillon (FR)**

(74) Mandataire: **Cabinet Camus Lebkiri
25 rue de Maubeuge
75009 Paris (FR)**

(56) Documents cités:
**US-A1- 2009 261 313    US-A1- 2010 084 741
US-A1- 2015 236 256**

## Description

## DOMAINE TECHNIQUE DE L'INVENTION

Le domaine technique de l'invention est celui des mémoires réinscriptibles non volatiles, et plus spécifiquement celui des mémoires résistives de type OxRRAM et CBRAM. La présente invention concerne en particulier une mémoire résistive, un procédé de fabrication d'une mémoire résistive, un procédé de fabrication d'une pluralité de mémoires résistives et un procédé de programmation d'une mémoire résistive.

## ARRIERE-PLAN TECHNOLOGIQUE DE L'INVENTION

Les mémoires résistives, ou mémoires RRAM (de l'anglais « Resistive Random Access Memory ») sont étudiées dans le cadre d'applications non-volatiles ; elles représentent notamment une alternative à l'utilisation de mémoires Flash.

Une mémoire résistive comprend des première et seconde électrodes séparées par une couche en matériau actif. Dans l'état initial, le matériau actif est isolant (état PRS, « Pristine Résistance State »). Un premier stress électrique est appliqué sur la mémoire résistive vierge afin de générer pour la première fois un état conducteur faiblement résistif LRS (de l'anglais « Low Résistance State »). Le processus associé est appelé FORMING. La mémoire résistive peut ensuite basculer de l'état conducteur faiblement résistif LRS à un état conducteur hautement résistif HRS (de l'anglais « High Résistance State ») par l'application d'une première tension VRESET entre les première et seconde électrodes, et rebasculer de l'état conducteur hautement résistif HRS à l'état conducteur faiblement résistif LRS par l'application d'une deuxième tension VSET entre les première et deuxième électrodes. Elle peut donc être utilisée pour stocker une information binaire. L'état conducteur faiblement résistif LRS est également appelé état « ON ». L'état conducteur hautement résistif HRS est également appelé état « OFF ».

Le phénomène de changement de résistance est observé dans différents types de matériaux, ce qui suggère des mécanismes de fonctionnement différents. On peut ainsi distinguer plusieurs types de mémoires résistives. Le domaine de la présente invention concerne plus particulièrement deux catégories de mémoires résistives :

- les mémoires comportant une zone active basée sur un matériau actif à base d'oxyde (mémoire OxRRAM ou « Oxyde RRAM ») tel qu'un oxyde binaire d'un métal de transition ;
- les mémoires comportant une zone active basée sur un matériau à conduction ionique (mémoires CBRAM ou « Conductive Bridging RAM ») formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode.

Le changement d'état résistif dans une mémoire résistive de type OxRRAM est généralement expliqué par la formation d'un filament de lacunes d'oxygènes au sein de la zone active. Le changement d'état résistif dans une mémoire résistive de type CBRAM est généralement expliqué par la formation d'un filament conducteur au sein de la zone active.

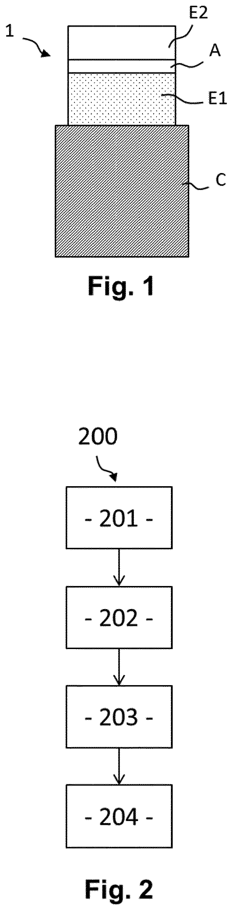

Du point de vue de l'architecture, une mémoire résistive est généralement associée à un dispositif de sélection qui peut par exemple être un transistor ou une diode. Au sein d'une matrice comportant une pluralité de mémoires résistives, on prévoit donc un dispositif de sélection pour chaque mémoire résistive. Chaque mémoire résistive peut être connectée à son dispositif de sélection par un élément connecteur tel qu'un via ou trou d'interconnexion. Il s'agit alors d'aligner chaque mémoire résistive avec un tel élément connecteur. La qualité de l'alignement dépend typiquement des performances de l'équipement de lithographie utilisé. C'est un paramètre qui peut avoir un impact sur la variabilité des dispositifs obtenus. Il s'agit donc d'un paramètre potentiellement contraignant dans le cadre d'une intégration industrielle. La figure 1 montre schématiquement une mémoire résistive 1 comportant une première électrode E1, une deuxième électrode E2 et une couche en matériau actif A agencée entre les première et deuxième électrodes. La première électrode E1 de la mémoire résistive 1 est agencée au contact d'un élément connecteur C, qui permet un contact électrique avec un dispositif de sélection non représenté.

De nombreuses études portent par ailleurs sur les mémoires résistives afin d'améliorer leur fiabilité et leurs performances. Une difficulté concerne la dispersion de certaines caractéristiques électriques. Une dispersion importante des tensions de SET et de RESET et/ou des états résistifs est en effet mesurée d'une mémoire résistive à l'autre, mais également cycle-à-cycle pour une même mémoire résistive. Une raison proposée pour expliquer cette dispersion porte sur la difficulté à contrôler la taille et la position du filament au sein de la couche en matériau actif. Par ailleurs, la référence est faite au l'art antérieure montré dans les documents US2010084741, US2015236256 et US2009261313 décrivant de nombreux mémoires résistives.

## RESUME DE L'INVENTION

La présente invention vise à diminuer la variabilité des caractéristiques électriques d'une mémoire résistive tout en relâchant les contraintes d'alignement lors de la fabrication de ladite mémoire résistive.

Un premier aspect de l'invention selon la revendication indépendante 1 concerne un procédé de fabrication d'une pluralité de mémoires résistives, chaque mémoire résistive comprenant une première électrode et une seconde électrode séparées par une couche en matériau actif, chaque mémoire résistive étant initialement dans un état isolant et passant de l'état isolant à un état conducteur par l'application d'une tension seuil VFORMING entre les première et seconde électrodes.

On entend par « la deuxième électrode est alignée avec au moins une première électrode en contact avec l'élément connecteur » le fait qu'il existe au moins un premier plan perpendiculaire au plan de référence et traversant à la fois la deuxième électrode et la première surface d'extrémité d'au moins une première électrode en contact avec l'élément connecteur.

Grâce au procédé de fabrication d'une pluralité de mémoires résistives selon le premier aspect de l'invention, on réalise une pluralité d'éléments connecteurs avec un pas Cp suivant la première direction, chaque élément connecteur ayant une largeur Cb mesurée suivant la première direction, et une pluralité de premières électrodes avec un pas Ep suivant la première direction, chaque première électrode ayant une deuxième surface d'extrémité de largeur Eb suivant la première direction. La largeur Eb de la deuxième surface d'extrémité de chaque première électrode est avantageusement choisie telle que : $Eb < Cp - Cb$. Ainsi, on empêche avantageusement qu'une même première électrode soit en contact avec deux éléments connecteurs différents. Autrement dit, on garantit que chaque première électrode ne sera en contact qu'avec un seul élément connecteur au maximum. Il est possible qu'une première électrode ne soit en contact avec aucun élément connecteur. Le pas Ep et la largeur Eb sont avantageusement choisis de manière que leur différence soit inférieure ou égale à la différence du pas Cp et de la largeur Cb de l'élément connecteur. On garantit ainsi qu'il y a toujours au moins une première électrode en contact avec chaque élément connecteur, sans aucune contrainte d'alignement entre la pluralité d'éléments connecteurs et la pluralité de premières électrodes. Il est possible que plusieurs premières électrodes soient en contact avec un même élément connecteur, ce qui n'est pas préjudiciable au bon fonctionnement ultérieur de la mémoire résistive. Dans le cas où une deuxième électrode est alignée avec plusieurs premières électrodes en contact avec un élément connecteur, lesdites premières électrodes se trouvent en effet en compétition les unes avec les autres lors de l'étape de FORMING - pendant laquelle la tension seuil VFORMING est appliquée entre la pluralité de premières électrodes d'une part et la deuxième électrode d'autre part. On considère que la formation d'un filament conducteur débute, au sein de la couche en matériau actif, en regard de chacune desdites premières électrodes. Tous les filaments conducteurs ne se forment toutefois pas à la même vitesse. La première électrode en regard de laquelle le filament conducteur est entièrement créé le premier détermine ainsi l'unique point mémoire fonctionnel finalement réalisé. Dès que le premier filament conducteur est créé, la formation des autres filaments conducteurs est inhibée. Par ailleurs, pour chaque première électrode, l'aire de la première surface d'extrémité est avantageusement inférieure à l'aire de la deuxième surface d'extrémité afin de pouvoir contrôler le cas échéant la taille et la position du filament au sein de la couche en matériau actif.

Outre les caractéristiques qui viennent d'être évoquées dans le paragraphe précédent, le procédé de fabrication d'une mémoire résistive selon le premier aspect de l'invention peut présenter une ou plusieurs caractéristiques complémentaires parmi les suivantes, considérées individuellement ou selon toutes les combinaisons techniquement possibles :

- Le pas Ep peut être choisi tel que : $0 < Ep < Cb$. On garantit dans ce cas qu'il y a toujours au moins deux premières électrodes en contact avec l'élément connecteur, sans aucune contrainte d'alignement entre l'élément connecteur et la pluralité de premières électrodes.

- Chaque élément connecteur de la pluralité d'éléments connecteurs est préférentiellement un via ou trou d'interconnexion.

- Chaque deuxième électrode est préférentiellement une ligne d'interconnexion.

- La couche en matériau actif est avantageusement déposée au contact de la première surface d'extrémité de chaque première électrode. On simplifie ainsi le dépôt de la couche en matériau actif.

Selon un premier mode de réalisation, l'étape de réalisation de la pluralité de premières électrodes comprend les sous-étapes suivantes :

- une sous-étape de dépôt, sur une couche en matériau diélectrique comportant la pluralité d'éléments connecteurs, d'une couche d'un matériau conducteur ;
- une sous-étape de dépôt, sur la couche du matériau conducteur, d'une couche de résine ;
- une sous-étape de structuration de la couche de résine pour l'obtention d'une pluralité de motifs de résine avec le pas Ep suivant la première direction, chaque motif de résine comportant une première surface d'extrémité et une deuxième surface d'extrémité ayant une aire supérieure à l'aire de la première surface d'extrémité, la deuxième surface d'extrémité étant en contact avec la couche du matériau conducteur, la deuxième surface d'extrémité ayant la largeur Eb suivant la première direction ;

- une sous-étape de gravure anisotrope de l'empilement formé par la pluralité de motifs de résine et la couche du matériau conducteur, avec arrêt sur la couche en matériau diélectrique, pour l'obtention de la pluralité de premières électrodes ;

- une sous-étape de dépôt d'une deuxième couche d'un matériau diélectrique de manière à recouvrir la pluralité de premières électrodes ;
- une sous-étape de retrait partiel de la deuxième couche de matériau diélectrique de manière à dégager la première surface d'extrémité de chaque première électrode.

Ce premier mode de réalisation présente l'avantage de permettre un transfert de forme simple et répétable, depuis les motifs de résine vers le matériau conducteur, pour l'obtention de la pluralité de premières électrodes.

Selon un deuxième mode de réalisation, l'étape de réalisation de la pluralité de premières électrodes comprend les sous-étapes suivantes :

- une sous-étape de dépôt, sur une couche en matériau diélectrique comportant la pluralité d'éléments connecteurs, d'une couche d'un matériau conducteur ;
- une sous-étape de réalisation, sur la couche du matériau conducteur, d'une pluralité de masques avec le pas Ep suivant la première direction, chaque masque ayant une largeur suivant la première direction au moins égale à la largeur Eb ;
- une sous-étape de gravure isotrope pour l'obtention de la pluralité de premières électrodes ;
- une sous-étape de retrait de la pluralité de masques ;
- une sous-étape de dépôt d'une deuxième couche d'un matériau diélectrique de manière à recouvrir la pluralité de premières électrodes ;
- une sous-étape de retrait partiel de la deuxième couche de matériau diélectrique de manière à dégager la première surface d'extrémité de chaque première électrode.

La sous-étape de retrait partiel peut être réalisée par une technique de polissage mécano-chimique.

Alternativement, la sous-étape de retrait partiel peut comporter :

- une première sous-étape de polissage mécano-chimique ne débouchant pas sur la première surface d'extrémité de chaque première électrode, et
- une deuxième sous-étape de gravure afin de libérer la première surface d'extrémité de chaque première électrode.

Lorsque la sous-étape de retrait partiel est uniquement réalisée par une technique de polissage mécano-chimique, au moins une cale est avantageusement préalablement réalisée dans le matériau conducteur en plus de la pluralité de premières électrodes, la cale présentant une hauteur, mesurée suivant une direction perpendiculaire au plan de référence, sensiblement égale à la hauteur de chaque première électrode et ayant une première surface d'extrémité plus grande que la première surface d'extrémité de chaque première électrode de manière à former une surface d'arrêt lors d'un polissage mécano-chimique.

Un deuxième aspect de l'invention concerne une pluralité de mémoires résistives susceptible d'être obtenue par un procédé de fabrication selon le premier aspect de l'invention, chaque mémoire de la pluralité de mémoires résistives comprenant une première électrode et une seconde électrode séparées par une couche en matériau actif, la pluralité de mémoires résistives comportant :

- une pluralité d'éléments connecteurs s'étendant sensiblement suivant un plan de référence avec un pas Cp suivant une première direction parallèle au plan de référence R, chaque élément connecteur ayant une largeur Cb mesurée suivant la première direction ;
- une pluralité de premières électrodes avec un pas Ep suivant la première direction, chaque première électrode ayant une première surface d'extrémité et une deuxième surface d'extrémité, la deuxième surface d'extrémité ayant une largeur Eb mesurée suivant la première direction et une aire supérieure à l'aire de la première surface d'extrémité ;

chaque élément connecteur étant en contact direct avec au moins une première électrode et au moins une première électrode n'étant en contact direct avec aucun élément connecteur.

Un troisième aspect de l'invention concerne une pluralité de mémoires résistives susceptible d'être obtenue par un procédé de fabrication selon le premier aspect de l'invention, chaque mémoire de la pluralité de mémoires résistives comprenant une première électrode et une seconde électrode séparées par une couche en matériau actif, la pluralité de mémoires résistives comportant :

- une pluralité d'éléments connecteurs s'étendant sensiblement suivant un plan de référence avec un pas Cp suivant une première direction parallèle au plan de référence R, chaque élément connecteur ayant une largeur Cb mesurée suivant la première direction ;
- une pluralité de premières électrodes avec un pas Ep suivant la première direction, chaque première électrode ayant une première surface d'extrémité et une deuxième surface d'extrémité, la deuxième surface d'extrémité ayant une largeur Eb mesurée suivant la première direction et une aire supérieure à l'aire de la première surface d'extrémité ;

chaque élément connecteur étant en contact direct avec au moins une première électrode et au moins un élément connecteur étant en contact direct avec plusieurs premières électrodes.

Un quatrième aspect de l'invention concerne une pluralité de mémoires résistives susceptible d'être obtenue par un procédé de fabrication selon le premier aspect de l'invention, chaque mémoire de la pluralité de mémoires résistives comprenant une première électrode et une seconde électrode séparées par une couche en matériau actif, la pluralité de mémoires résistives comportant :

- une pluralité d'éléments connecteurs s'étendant sensiblement suivant un plan de référence avec un pas Cp suivant une première direction parallèle au plan de référence R, chaque élément connecteur ayant une largeur Cb mesurée suivant la première direction ;
- une pluralité de premières électrodes avec un pas Ep suivant la première direction, chaque première électrode ayant une première surface d'extrémité et une deuxième surface d'extrémité, la deuxième surface d'extrémité ayant une largeur Eb mesurée suivant la première direction et une aire supérieure à l'aire de la première surface d'extrémité ;

chaque élément connecteur étant en contact direct avec au moins une première électrode, au moins une première électrode n'étant en contact direct avec aucun élément connecteur, et au moins un élément connecteur étant en contact direct avec plusieurs premières électrodes.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1 montre une représentation schématique d'une mémoire résistive selon l'état de la technique.
- La figure 2 montre un diagramme des étapes d'un procédé de fabrication d'une pluralité de mémoires résistives selon un aspect de l'invention.
- La figure 3a montre schématiquement une vue en coupe d'une première pluralité de mémoires résistives obtenue selon le procédé de la figure 2.
- La figure 3b montre schématiquement une vue en coupe d'une deuxième pluralité de mémoires résistives obtenue selon le procédé de la figure 2.
- Les figures 4a, 4b, 4c, 4d et 4e illustrent respectivement des première, deuxième, troisième, quatrième et cinquième géométries possibles d'une première électrode d'une mémoire résistive obtenue selon le procédé de la figure 2.
- Les figures 5a, 5b, 5c et 5d montrent des sous-étapes d'une étape de réalisation d'une pluralité de premières électrodes du procédé de la figure 2, selon un premier mode de réalisation.

- Les figures 6a, 6b, 6c et 6d montrent des sous-étapes d'une étape de réalisation d'une pluralité de premières électrodes du procédé de la figure 2, selon un deuxième mode de réalisation.
- La figure 7 montre un exemple de cale pouvant être utilisé lors du procédé de la figure 2.
- La figure 8a montre schématiquement une première vue de dessus en coupe d'une pluralité de mémoires résistives obtenue par le procédé de la figure 2.
- La figure 10b montre schématiquement une deuxième vue de dessus en coupe de la pluralité de mémoires résistives de la figure 8a.
- La figure 11 montre schématiquement une vue en perspective d'une pluralité de mémoires résistives obtenue par le procédé de la figure 2.

**DESCRIPTION DETAILLEE D'AU MOINS UN MODE DE REALISATION DE L'INVENTION**

Sauf précision contraire, un même élément apparaissant sur des figures différentes présente une référence unique.

La figure 1, qui montre une représentation schématique d'une mémoire résistive 1 selon l'état de la technique, a été précédemment décrite.

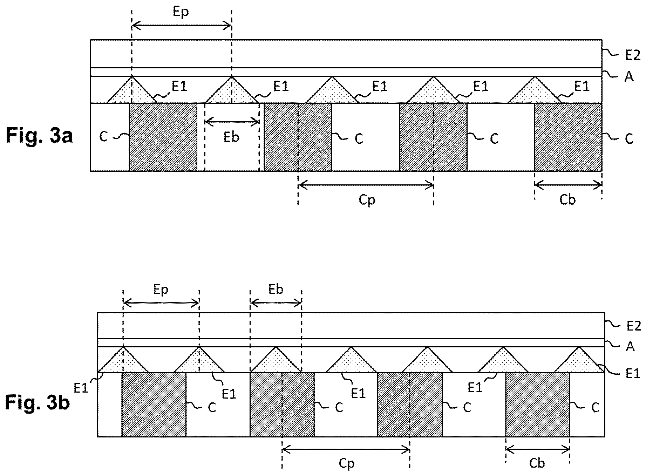

La figure 2 montre un diagramme des étapes d'un procédé 200, selon un aspect de l'invention, de fabrication d'une pluralité de mémoires résistives. La figure 3a montre schématiquement une vue en coupe d'une première pluralité de mémoires résistives obtenue selon le procédé 200. La figure 3b montre schématiquement une vue en coupe d'une deuxième pluralité de mémoires résistives obtenue selon le procédé 200. Les figures 2, 3a et 3b sont décrites conjointement.

Le procédé 200 de fabrication d'une mémoire résistive comporte une étape 201 selon laquelle on réalise une pluralité d'éléments connecteurs C s'étendant sensiblement suivant un plan de référence R avec un pas Cp suivant une première direction parallèle au plan de référence R, chaque élément connecteur C ayant une largeur Cb mesurée suivant la première direction. Chaque élément connecteur C permet une reprise de contact électrique et est typiquement réalisé au sein d'une couche en matériau diélectrique. Chaque élément connecteur C est préférentiellement un via ou trou d'interconnexion.

Le procédé 200 de fabrication d'une pluralité de mémoires résistives comporte ensuite une étape 202 selon laquelle on réalise une pluralité de premières électrodes E1 avec un pas Ep suivant la première direction, chaque première électrode E1 ayant une première surface d'extrémité ex1 et une deuxième surface d'extrémité ex2, la deuxième surface d'extrémité ex2 ayant une largeur Eb mesurée suivant la première direction et une aire supérieure à l'aire de la première surface d'extrémité ex1 ; le pas Ep et la largeur Eb étant tels que : $0 < Ep - Eb < Cp - Cb$, de sorte que, pour chaque élément connecteur C, au moins une première électrode E1 est en contact, via sa deuxième surface d'extrémité ex2, avec ledit élément connecteur C.

Chaque première électrode E1 présente une hauteur Eh, mesurée suivant une direction perpendiculaire au plan de référence R entre sa première surface d'extrémité ex1 et sa deuxième surface d'extrémité ex2. Pour chaque première électrode E1, le rapport Eh/Eb de la hauteur Eh sur la largeur Eb est préférentiellement de l'ordre de 2 est peut par exemple être compris entre 1 et 3. Un rapport Eh/Eb de la hauteur Eh sur la largeur Eb trop élevé a pour conséquence une instabilité mécanique, notamment lors du polissage mais aussi lors de la gravure. Un rapport Eh/Eb de la hauteur Eh sur la largeur Eb trop faible a pour conséquence une trop grande variabilité de la première surface de contact ex1 de chaque première électrode E1. La hauteur Eh de chaque première électrode E1 est préférentiellement comprise entre 50 nm et 300 nm. La largeur Eb de chaque première électrode E1 est donc préférentiellement comprise entre 16 nm et 300 nm, et plus préférentiellement comprise entre 25 nm et 150 nm.

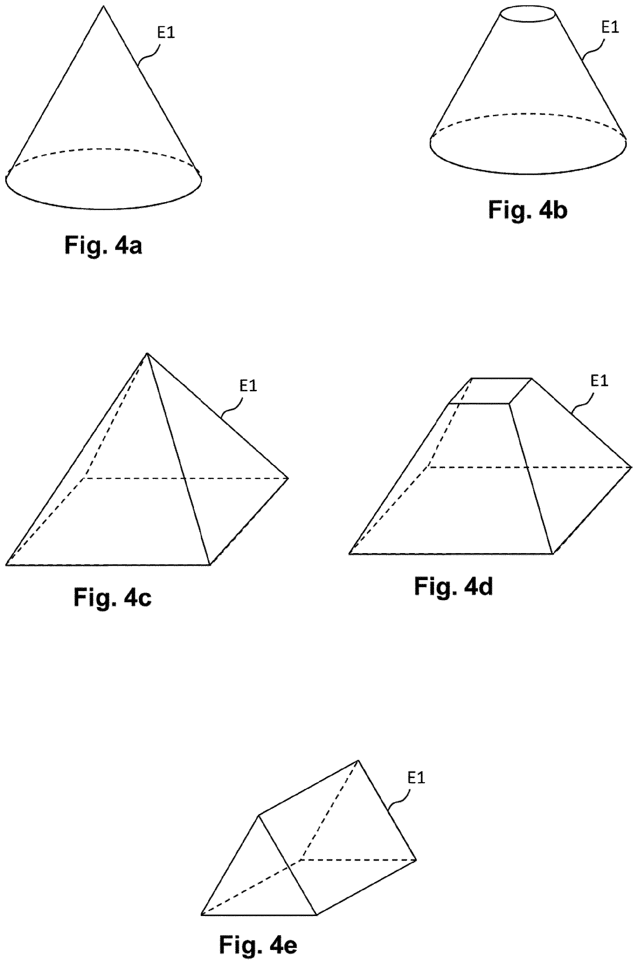

Chaque première électrode E1 peut notamment être de forme conique, ou de forme tronconique, ou en forme de prisme. La figure 4a montre un premier exemple de première électrode E1 en forme de cône ; la première électrode E1 de la figure 4a est plus particulièrement un cône de révolution. La figure 4c montre un deuxième exemple de première électrode E1 en forme de cône ; la première électrode E1 de la figure 4c est plus particulièrement une pyramide. La figure 4b montre un premier exemple de première électrode E1 de forme tronconique. La figure 4d montre un deuxième exemple de première électrode E1 de forme tronconique. La figure 4e montre un exemple de première électrode E1 en forme de prisme.

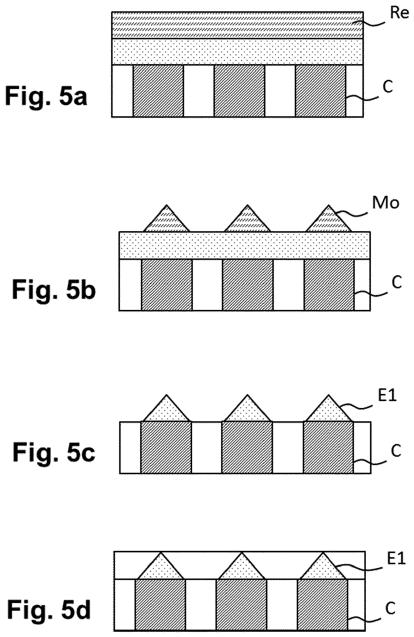

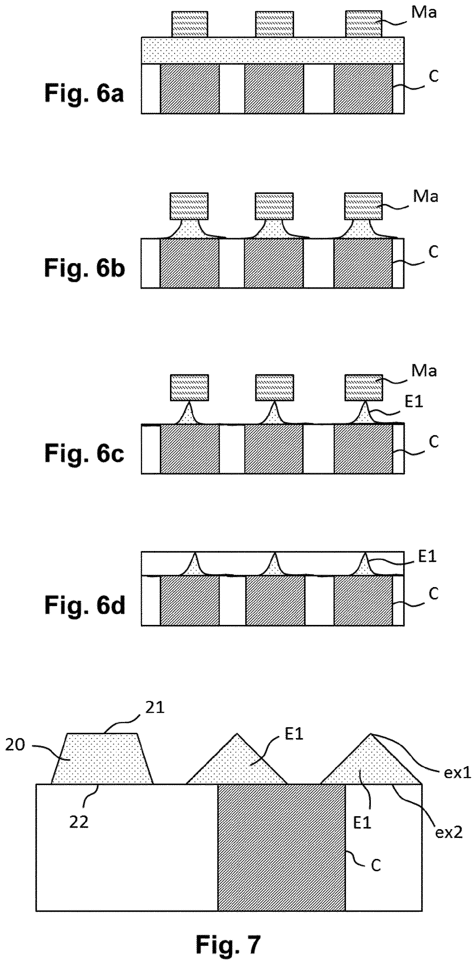

Un premier mode de réalisation de l'étape 202 de réalisation de la pluralité de premières électrodes E1 est ultérieurement décrit en lien avec les figures 5a, 5b, 5c et 5. Un deuxième mode de réalisation de l'étape 202 de réalisation de la pluralité de premières électrodes E1 est ultérieurement décrit en lien avec les figures 6a, 6b, 6c et 6d.

Le procédé 200 de fabrication d'une pluralité de mémoires résistives comporte ensuite une étape 203 selon laquelle on dépose une couche en matériau actif A au contact, pour chaque élément connecteur C, de la première surface d'extrémité ex1 d'au moins une première électrode E1 en contact avec ledit élément connecteur C. Le matériau actif A est par exemple de l'oxyde d'hafnium $HfO_2$, ou un nitrure, ou un oxyde. La couche en matériau actif A est avantageusement déposée au contact de la première surface d'extrémité ex1 de chaque première électrode E1. On simplifie ainsi le dépôt de la couche en matériau actif A.

Le procédé 200 de fabrication d'une mémoire résistive comporte ensuite une étape 204 selon laquelle on réalise, sur la couche en matériau actif A, au moins une deuxième électrode E2 de manière que pour chaque élément connecteur C, la deuxième électrode E2 est alignée avec au moins une première électrode E1 en contact avec ledit élément connecteur C, et la deuxième électrode est séparée de ladite au moins une première électrode E1 par la couche en matériau actif A. La deuxième électrode E2 est par exemple réalisée en titane Ti, en nitrure de titane TiN, en tantale Ta ou en nitrure de tantale TaN. La deuxième électrode E2 peut notamment être un alliage de titane Ti et/ou nitrure de titane TiN et/ou tantale Ta et/ou nitrure de tantale TaN. La deuxième électrode E2 peut également être une multicouche comportant une couche de titane Ti et/ou une couche de nitrure de titane TiN et/ou une couche de tantale Ta et/ou une couche de nitrure de tantale TaN et/ou une couche d'un alliage des matériaux précédemment cités. La deuxième électrode E2 est préférentiellement une ligne d'interconnexion.

La figure 3a montre en particulier une première pluralité de mémoires résistives obtenue par le procédé 200. Dans cet exemple particulier, chaque élément connecteur C est en contact avec une unique première électrode E1. Il est possible qu'une première électrode E1 ne soit en contact avec aucun élément connecteur C. La largeur Eb de chaque première électrode E1 est inférieure à la distance (Cp - Cb) qui sépare deux éléments connecteurs C consécutifs alignés suivant la première direction. Ainsi, une même première électrode E1 ne peut pas être en contact avec plus d'un élément connecteur C.

La figure 3b montre en particulier une deuxième pluralité de mémoires résistives obtenue par le procédé 200. Dans cet exemple particulier, chaque élément connecteur C est en contact avec une ou deux premières électrodes E1. Il est possible qu'une première électrode E1 ne soit en contact avec aucun élément connecteur C. La largeur Eb de chaque première électrode E1 est inférieure à la distance (Cp - Cb) qui sépare deux éléments connecteurs C consécutifs alignés suivant la première direction.

Le premier mode de réalisation de l'étape 202 de réalisation de la pluralité de premières électrodes E1 est à présent décrit, en lien avec les figures 5a, 5b, 5c et 5d. L'étape 202 de réalisation de la pluralité de premières électrodes E1 comporte, selon le premier mode de réalisation, une première sous-étape de dépôt, sur une couche en matériau diélectrique comportant l'élément connecteur C, d'une couche d'un matériau conducteur. La couche du matériau conducteur a une épaisseur, mesurée suivant une direction perpendiculaire au plan de référence R, supérieure ou égale à la hauteur Eh souhaitée pour chaque première électrode E1. La couche du matériau conducteur a préférentiellement une épaisseur comprise entre 50 nm et 300 nm. Le matériau conducteur peut par exemple être du nitrure de titane TiN, du titane Ti, du nitrure de tantale TaN ou du tantale Ta.

L'étape 202 de réalisation de la pluralité de premières électrodes E1 comporte ensuite, selon le premier mode de réalisation, une deuxième sous-étape de dépôt, sur la couche du matériau conducteur, d'une couche de résine Re. Cette deuxième sous-étape est illustrée à la figure 5a.

L'étape 202 de réalisation de la pluralité de premières électrodes E1 comporte ensuite, selon le premier mode de réalisation, une troisième sous-étape de structuration de la couche de résine pour l'obtention d'une pluralité de motifs Mo de résine avec le pas Ep suivant la première direction, chaque motif Mo de résine comportant une première surface d'extrémité et une deuxième surface d'extrémité ayant une aire supérieure à l'aire de la première surface d'extrémité, la deuxième surface d'extrémité étant en contact avec la couche du matériau conducteur, la deuxième surface d'extrémité ayant la largeur Eb suivant la première direction. La structuration de la couche de résine peut être réalisée par une technique de nano-impression ou de nano-moulage. La structuration de la couche de résine peut alternativement être réalisée par une étape de lithographie conventionnelle. Dans cette alternative, le premier mode de réalisation de l'invention permet avantageusement de s'affranchir de l'utilisation des techniques de lithographies les plus agressives tout en obtenant finalement une zone mémoire, entre les première et seconde électrodes de chaque mémoire résistive, de dimensions très réduites. Il peut être prévu une étape de durcissement de la résine. Cette troisième sous-étape est illustrée à la figure 5b.

L'étape 202 de réalisation de la pluralité de premières électrodes E1 comporte ensuite, selon le premier mode de réalisation, une quatrième sous-étape de gravure anisotrope de l'empilement formé par la pluralité de motifs de résine et la couche du matériau conducteur, avec arrêt sur la couche en matériau diélectrique, pour l'obtention de la pluralité de premières électrodes E1. Avoir préalablement réalisé une étape de durcissement de la résine permet de minimiser la vitesse de gravure desdits motifs. L'objectif est de parvenir à une sélectivité de gravure sensiblement égale à 1 entre le matériau conducteur et la résine, ou autrement dit de parvenir à graver le matériau conducteur et la résine sensiblement à la même vitesse. Si la sélectivité de gravure entre le matériau conducteur et la résine est supérieure à 1, c'est-à-dire si le matériau conducteur est gravé plus vite que la résine, on choisit préférentiellement au préalable de déposer une épaisseur de la couche de résine Re, mesurée suivant une direction perpendiculaire au plan de référence R, inférieure à la hauteur Eh souhaitée pour chaque première électrode E1. Autrement dit, on prévoit que la hauteur de chaque motif Mo structuré est inférieure à la hauteur Eh de la première électrode E1 qu'il sert à réaliser par transfert. Si au contraire la sélectivité de gravure entre le matériau conducteur et la résine est inférieure à 1, c'est-à-dire si le matériau conducteur est gravé moins vite que la résine, on choisit préférentiellement au préalable de déposer une épaisseur de la couche de résine Re, mesurée suivant une direction perpendiculaire au plan de référence R, supérieure à la hauteur Eh souhaitée pour chaque première électrode E1. Autrement dit, on prévoit que la hauteur de chaque motif Mo structuré est supérieure à la hauteur Eh de la première électrode E1 qu'il sert à réaliser par transfert. On permet ainsi un transfert optimum de la forme de chaque motif Mo de résine dans le matériau conducteur, pour l'obtention de la pluralité de premières électrodes E1 en matériau conducteur. La gravure anisotrope peut être réalisée au moyen d'une technique de gravure ionique réactive RIE (de l'anglais « reactive-ion etching ») de type chlorée, avec par exemple du trichlorure de bore $BCl_3$ ou du dichlore $Cl_2$. Cette quatrième sous-étape est illustrée à la figure 5c.

L'étape 202 de réalisation de la pluralité de premières électrodes E1 comporte ensuite, selon le premier mode de réalisation, une cinquième sous-étape de dépôt d'une deuxième couche d'un matériau diélectrique de manière à recouvrir la pluralité de premières électrodes E1, puis une sixième sous-étape de retrait partiel de la deuxième couche de matériau diélectrique de manière à dégager la première surface d'extrémité ex1 de chaque première électrode E1. Cette sixième sous-étape est illustrée à la figure 5d.

Le premier mode de réalisation qui vient d'être décrit présente l'avantage de permettre un transfert de forme simple et répétable, depuis les motifs de résine vers le matériau conducteur, pour l'obtention de la pluralité de premières électrodes.

Le deuxième mode de réalisation de l'étape 202 de réalisation de la pluralité de premières électrodes E1 est à présent décrit, en lien avec les figures 6a, 6b, 6c, et 6d. L'étape 202 de réalisation de la pluralité de premières électrodes E1 comporte, selon le deuxième mode de réalisation, la première sous-étape de dépôt, sur une couche en matériau diélectrique comportant l'élément connecteur C, d'une couche d'un matériau conducteur. Cette première sous-étape a été précédemment décrite, elle est commune aux premier et deuxième modes de réalisation.

L'étape 202 de réalisation de la pluralité de premières électrodes E1 comporte ensuite, selon le deuxième mode de réalisation, une deuxième sous-étape de réalisation d'une pluralité de masques Ma. Cette deuxième sous-étape est illustrée à la figure 6a. La pluralité de masques Ma est par exemple obtenue en déposant une couche d'un matériau de masque sur la couche du matériau conducteur, puis en réalisant une lithographie conventionnelle. Dans cet exemple, le deuxième mode de réalisation de l'invention permet avantageusement de s'affranchir de l'utilisation des techniques de lithographies les plus agressives tout en obtenant finalement une zone mémoire, entre les première et seconde électrodes de chaque mémoire résistive, de dimensions très réduites.

L'étape 202 de réalisation de la pluralité de premières électrodes E1 comporte ensuite, selon le deuxième mode de réalisation, une troisième sous-étape de gravure isotrope, pour l'obtention de la pluralité de premières électrodes E1. Cette troisième sous-étape est illustrée aux figures 6b et 6c.

L'étape 202 de réalisation de la pluralité de premières électrodes E1 comporte ensuite, selon le deuxième mode de réalisation, une quatrième sous-étape de retrait de la pluralité de masques Ma, puis une cinquième sous-étape de dépôt d'une deuxième couche d'un matériau diélectrique de manière à recouvrir la pluralité de premières électrodes E1, suivie d'une sixième sous-étape de retrait partiel de la deuxième couche de matériau diélectrique de manière à dégager la première surface d'extrémité ex1 de chaque première électrode E1. Cette sixième sous-étape est illustrée à la figure 6d. Les cinquième et sixième sous-étapes sont communes aux premier et deuxième modes de réalisation.

La sixième sous-étape de retrait partiel de la deuxième couche de matériau diélectrique, commune aux premier et deuxième modes de réalisation, peut être réalisée de différentes manières. Une première possibilité est d'utiliser une technique de polissage mécano-chimique afin de déboucher sur la première surface d'extrémité ex1 de chaque première électrode E1. Une ou plusieurs cales (« dummies » en langue anglaise) peuvent avoir été réalisées dans le matériau conducteur, en plus de la pluralité de premières électrodes. La figure 7 montre par exemple une cale 20 comportant une première surface d'extrémité 21 et une deuxième surface d'extrémité 22. La cale 20 présente une hauteur, mesurée suivant une direction perpendiculaire au plan de référence R, sensiblement égale à la hauteur Eh de chaque première électrode E1. La première surface d'extrémité 21 de la cale 20 est plus grande que la première surface d'extrémité ex1 de chaque première électrode E1 et forme une surface d'arrêt efficace lors d'un polissage mécano-chimique. Ainsi, on protège la première surface d'extrémité ex1 de chaque première électrode, qui n'est que peu polie ou pas du tout polie lors du polissage mécano-chimique. On obtient pour chaque première électrode E1 une première surface d'extrémité ex1 qui est avantageusement la plus petite possible, afin de contrôler la taille et la position du filament au sein de la couche en matériau actif. La ou les cales peuvent par exemple être de forme cylindrique ou tronconique, comme représenté à la figure 7.

Une deuxième possibilité est de réaliser une première sous-étape de polissage mécano-chimique afin d'obtenir une surface plane de la couche de deuxième matériau diélectrique, mais sans déboucher sur la première surface d'extrémité ex1 de chaque première électrode E1. On réalise ensuite une deuxième sous-étape de gravure sèche et/ou humide afin de libérer la première surface d'extrémité ex1 de chaque première électrode E1. Le procédé de gravure utilisé est sélectif vis-à-vis du matériau conducteur des premières électrodes E1, afin que les premières électrodes E1 ne soient pas gravées, ou très peu gravées, durant cette deuxième sous-étape. On obtient ainsi pour chaque première électrode E1 une première surface d'extrémité ex1 qui est avantageusement la plus petite possible, afin de contrôler la taille et la position du filament au sein de la couche en matériau actif.

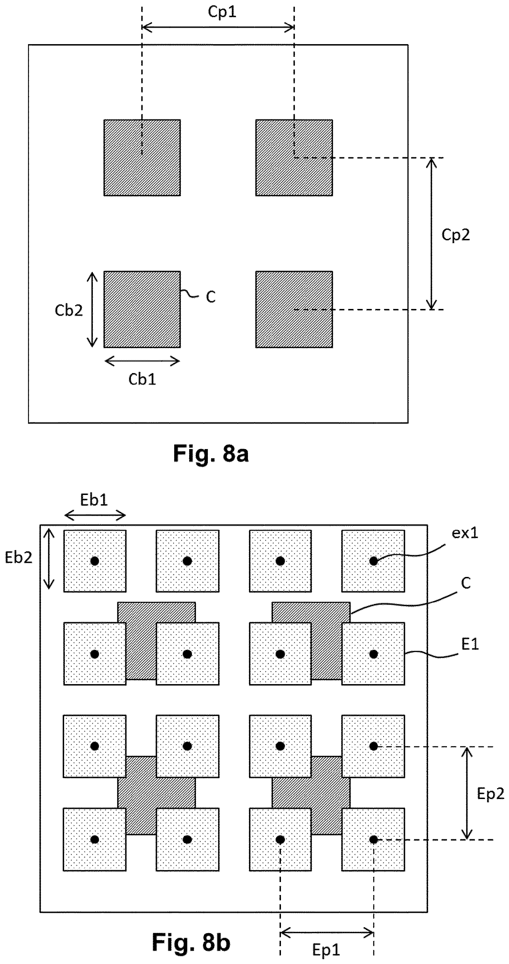

La figure 8a montre schématiquement une première vue de dessus en coupe d'une pluralité de mémoires résistives obtenue par le procédé 200. La figure 8b montre schématiquement une deuxième vue de dessus en coupe de la pluralité de mémoires résistives de la figure 8a. Les figures 8a et 8b sont décrites conjointement. Une pluralité d'éléments connecteurs C est disposée régulièrement avec un pas Cp1 suivant la première direction et un pas Cp2 suivant une deuxième direction parallèle au premier plan de référence R. La deuxième direction est distincte de la première direction. La deuxième direction est préférentiellement sensiblement perpendiculaire à la première direction. Chaque élément connecteur C présente une largeur Cb1 mesurée suivant la première direction et une longueur Cb2 mesurée suivant la deuxième direction. Une pluralité de premières électrodes E1 est disposée régulièrement avec un pas Ep1 suivant la première direction et un pas Ep2 suivant la deuxième direction. Chaque première électrode E1 présente une largeur Eb1 suivant la première direction et une longueur Eb2 suivant la deuxième direction. Suivant la première direction, les pas Ep1 et Cp1 et les largeurs Eb1 et Cb1 sont tels que :

$$0 < Ep1 - Eb1 \leq Cp1 - Cb1$$

et préférentiellement tels que :

$$Eb1 < Cp1 - Cb1$$

De même, suivant la deuxième direction, les pas Ep2 et Cp2 et les longueurs Eb2 et Cb2 sont tels que :

$$0 < Ep2 - Eb2 \leq Cp2 - Cb2$$

et préférentiellement tels que :

$$Eb2 < Cp2 - Cb2$$

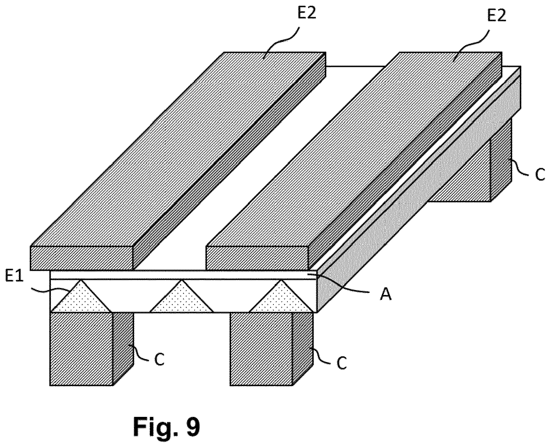

La figure 9 montre schématiquement une vue en perspective d'une pluralité de mémoires résistives obtenue par le procédé de fabrication 200 d'une pluralité de mémoires résistives selon un aspect de l'invention. Dans l'exemple préférentiel de la figure 9, chaque élément connecteur C est un via ou trou d'interconnexion, propre à chaque mémoire résistive, et chaque deuxième électrode E2 est une ligne d'interconnexion, commune à plusieurs mémoires résistives.

**Revendications**

1. Procédé (200) de fabrication d'une pluralité de mémoires résistives, chaque mémoire résistive comprenant une première électrode (E1) et une seconde électrode (E2) séparées par une couche en matériau actif (A), chaque mémoire résistive étant initialement dans un état isolant et passant de l'état isolant à un état conducteur par l'application d'une tension seuil VFORMING entre les première et seconde électrodes (E1, E2), le procédé de fabrication comportant :

   - une étape (201) de réalisation d'une pluralité d'éléments connecteurs (C) s'étendant sensiblement suivant un plan de référence (R) avec un pas Cp suivant une première direction parallèle au plan de référence (R), chaque élément connecteur ayant une largeur Cb mesurée suivant la première direction ;
   - une étape (202) de réalisation d'une pluralité de premières électrodes (E1) sur la pluralité d'éléments connecteurs (C), sans aucune contrainte d'alignement entre la pluralité d'éléments connecteurs (C) et la pluralité de premières électrodes (E1), la pluralité de premières électrodes (E1) ayant un pas Ep suivant la première direction, chaque première électrode (E1) ayant une première surface d'extrémité (ex1) et une deuxième surface d'extrémité (ex2), la deuxième surface d'extrémité (ex2) ayant une largeur Eb mesurée suivant la première direction et une aire supérieure à l'aire de la première surface d'extrémité (ex1) ; le pas Ep et la largeur Eb étant tels que :

$$0 < Ep - Eb \leq Cp - Cb$$
$$0 < Ep < Cb$$

   et :

$$Eb < Cp - Cb$$

   de sorte que, pour chaque élément connecteur (C) de la pluralité d'éléments connecteurs, au moins une première électrode (E1) de la pluralité de premières électrodes est en contact, via sa deuxième surface d'extrémité (ex2), avec ledit élément connecteur (C), et chaque première électrode (E1) n'est en contact, via sa deuxième surface d'extrémité (ex2), qu'avec au plus un élément connecteur (C) ;
   - une étape (203) de dépôt d'une couche en matériau actif (A) au contact, pour chaque élément connecteur (C), de la première surface d'extrémité (ex1) d'au moins une première électrode (E1) en contact direct avec ledit élément connecteur (C) ;
   - une étape (204) de réalisation, sur la couche en matériau actif (A), d'au moins une deuxième électrode (E2) de manière que pour chaque élément connecteur (C), la deuxième électrode (E2) est alignée avec au moins une première électrode (E1) en contact direct avec ledit élément connecteur (C), et la deuxième électrode est séparée de ladite au moins une première électrode (E1) par la couche en matériau actif (A).

2. Procédé (200) selon la revendication précédente **caractérisé en ce que** l'étape (202) de réalisation de la pluralité de premières électrodes (E1) comprend les sous-étapes suivantes :

   - une sous-étape de dépôt, sur une couche en matériau diélectrique comportant la pluralité d'éléments connecteurs (C), d'une couche d'un matériau conducteur ;
   - une sous-étape de dépôt, sur la couche du matériau conducteur, d'une couche de résine (Re) ;
   - une sous-étape de structuration de la couche de résine (Re) pour l'obtention d'une pluralité de motifs (Mo) de résine avec le pas Ep suivant la première direction, chaque motif (Mo) de résine comportant une première surface d'extrémité et une deuxième surface d'extrémité ayant une aire supérieure à l'aire de la première surface d'extrémité, la deuxième surface d'extrémité étant en contact avec la couche du matériau conducteur, la deuxième surface d'extrémité ayant la largeur Eb suivant la première direction ;
   - une sous-étape de gravure anisotrope de l'empilement formé par la pluralité de motifs (Mo) de résine et la couche du matériau conducteur, avec arrêt sur la couche en matériau diélectrique, pour l'obtention de la pluralité de premières électrodes (E1) ;
   - une sous-étape de dépôt d'une deuxième couche d'un matériau diélectrique de manière à recouvrir la pluralité de premières électrodes (E1) ;
   - une sous-étape de retrait partiel de la deuxième couche de matériau diélectrique de manière à dégager la première surface d'extrémité (ex1) de chaque première électrode (E1).

3. Procédé (200) selon l'une quelconque des revendications 1 à 2, **caractérisé en ce que** l'étape (202) de réalisation de la pluralité de premières électrodes (E1) comprend les sous-étapes suivantes :

- une sous-étape de dépôt, sur une couche en matériau diélectrique comportant la pluralité d'éléments connecteurs (C), d'une couche d'un matériau conducteur ;

- une sous-étape de réalisation, sur la couche du matériau conducteur, d'une pluralité de masques (Ma) avec le pas Ep suivant la première direction, chaque masque (Ma) ayant une largeur suivant la première direction au moins égale à la largeur Eb ;

- une sous-étape de gravure isotrope pour l'obtention de la pluralité de premières électrodes (E1) ;

- une sous-étape de retrait de la pluralité de masques (Ma) ;

- une sous-étape de dépôt d'une deuxième couche d'un matériau diélectrique de manière à recouvrir la pluralité de premières électrodes (E1) ;

- une sous-étape de retrait partiel de la deuxième couche de matériau diélectrique de manière à dégager la première surface d'extrémité (ex1) de chaque première électrode (E1).

4. Procédé selon l'une quelconque des revendications 2 ou 3 **caractérisé en ce que** la sous-étape de retrait partiel est réalisée par une technique de polissage mécano-chimique.

5. Procédé selon la revendication précédente **caractérisé en ce qu'**au moins une cale (20) a été préalablement réalisée dans le matériau conducteur en plus de la pluralité de premières électrodes, la cale (20) présentant une hauteur, mesurée suivant une direction perpendiculaire au plan de référence (R), sensiblement égale à la hauteur de chaque première électrode (E1) et ayant une première surface d'extrémité (21) plus grande que la première surface d'extrémité (ex1) de chaque première électrode (E1) de manière à former une surface d'arrêt lors d'un polissage mécano-chimique.

6. Procédé selon l'une quelconque des revendications 4 ou 5 **caractérisé en ce que** la sous-étape de retrait partiel comporte :

- une première sous-étape de polissage mécano-chimique ne débouchant pas sur la première surface d'extrémité (ex1) de chaque première électrode (E1), et

- une deuxième sous-étape de gravure afin de libérer la première surface d'extrémité (ex1) de chaque première électrode (E1).

7. Pluralité de mémoires résistives susceptible d'être obtenue par un procédé de fabrication selon l'une quelconque des revendications précédentes, chaque mémoire de la pluralité de mémoires résistives comprenant une première électrode (E1) et une seconde électrode (E2) séparées par une couche en matériau actif (A), la pluralité de mémoires résistives comportant :

- une pluralité d'éléments connecteurs (C) s'étendant sensiblement suivant un plan de référence (R) avec un pas Cp suivant une première direction parallèle au plan de référence R, chaque élément connecteur (C) ayant une largeur Cb mesurée suivant la première direction ;

- une pluralité de premières électrodes (E1) avec un pas Ep suivant la première direction, chaque première électrode (E1) ayant une première surface d'extrémité (ex1) et une deuxième surface d'extrémité (ex2), la deuxième surface d'extrémité ayant une largeur Eb mesurée suivant la première direction et une aire supérieure à l'aire de la première surface d'extrémité (ex1) ;

la pluralité de mémoires résistives étant **caractérisée en ce que** chaque élément connecteur (C) est en contact direct avec au moins une première électrode (E1) et **en ce qu'**au moins une première électrode (E1) n'est en contact direct avec aucun élément connecteur (C).

8. Pluralité de mémoires résistives susceptible d'être obtenue par un procédé de fabrication selon l'une quelconque des revendications 1 à 6, chaque mémoire de la pluralité de mémoires résistives comprenant une première électrode (E1) et une seconde électrode (E2) séparées par une couche en matériau actif (A), la pluralité de mémoires résistives comportant :

- une pluralité d'éléments connecteurs (C) s'étendant sensiblement suivant un plan de référence (R) avec un pas Cp suivant une première direction parallèle au plan de référence R, chaque élément connecteur (C) ayant une largeur Cb mesurée suivant la première direction ;

- une pluralité de premières électrodes (E1) avec un pas Ep suivant la première direction, chaque première électrode (E1) ayant une première surface d'extrémité (ex1) et une deuxième surface d'extrémité (ex2), la deuxième surface d'extrémité ayant une largeur Eb mesurée suivant la première direction et une aire supérieure à l'aire de la première surface d'extrémité (ex1) ;

la pluralité de mémoires résistives étant **caractérisée en ce que** chaque élément connecteur (C) est en contact direct avec au moins une première électrode (E1) et **en ce qu'**au moins un élément connecteur (C) est en contact direct avec plusieurs premières électrodes (E1).

**9.** Pluralité de mémoires résistives susceptible d'être obtenue par un procédé de fabrication selon l'une quelconque des revendications 1 à 6, chaque mémoire de la pluralité de mémoires résistives comprenant une première électrode (E1) et une seconde électrode (E2) séparées par une couche en matériau actif (A), la pluralité de mémoires résistives comportant :

> - une pluralité d'éléments connecteurs (C) s'étendant sensiblement suivant un plan de référence (R) avec un pas Cp suivant une première direction parallèle au plan de référence R, chaque élément connecteur (C) ayant une largeur Cb mesurée suivant la première direction ;
> - une pluralité de premières électrodes (E1) avec un pas Ep suivant la première direction, chaque première électrode (E1) ayant une première surface d'extrémité (ex1) et une deuxième surface d'extrémité (ex2), la deuxième surface d'extrémité ayant une largeur Eb mesurée suivant la première direction et une aire supérieure à l'aire de la première surface d'extrémité (ex1) ;

la pluralité de mémoires résistives étant **caractérisée en ce que** :

> - chaque élément connecteur (C) est en contact direct avec au moins une première électrode (E1),
> - au moins une première électrode (E1) n'est en contact direct avec aucun élément connecteur (C), et
> - au moins un élément connecteur (C) est en contact direct avec plusieurs premières électrodes (E1).

**Patentansprüche**

**1.** Verfahren (200) zum Herstellen einer Vielzahl von resistiven Speichern, wobei jeder resistive Speicher eine erste Elektrode (E1) und eine zweite Elektrode (E2) umfasst, die durch eine Schicht aus aktivem Material (A) getrennt sind, wobei sich jeder resistive Speicher anfänglich in einem isolierenden Zustand befindet und durch Anlegen einer Schwellenspannung VFORMING zwischen der ersten und der zweiten Elektrode (E1, E2) vom isolierenden Zustand in einen leitenden Zustand übergeht, wobei das Herstellungsverfahren Folgendes umfasst:

> - einen Schritt (201) zum Erzeugen einer Vielzahl von Verbindungselementen (C), die sich im Wesentlichen entlang einer Bezugsebene (R) mit einem Abstand Cp in einer ersten Richtung parallel zu der Bezugsebene (R) erstreckt, wobei jedes Verbindungselement eine Breite Cb, gemessen in der ersten Richtung, aufweist;
> - einen Schritt (202) zum Erzeugen einer Vielzahl von ersten Elektroden (E1) auf der Vielzahl von Verbindungselementen (C), ohne jegliche Einschränkung hinsichtlich der Ausrichtung zwischen der Vielzahl von Verbindungselementen (C) und der Vielzahl von ersten Elektroden (E1), wobei die Vielzahl der ersten Elektroden (E1) einen Abstand Ep in der ersten Richtung aufweist, jede erste Elektrode (E1) eine erste Endfläche (ex1) und eine zweite Endfläche (ex2) aufweist, wobei die zweite Endfläche (ex2) eine Breite Eb, gemessen in der ersten Richtung, und eine Oberfläche aufweist, die größer ist als die Oberfläche der ersten Endfläche (ex1); wobei der Abstand Ep und die Breite Eb so bemessen sind, dass:

$$0 < Ep - Eb \leq Cp - Cb$$

$$0 < Ep < Cb$$

und:

$$Eb < Cp - Cb$$

sodass bei jedem Verbindungselement (C) der Vielzahl von Verbindungselementen mindestens eine erste Elektrode (E1) der Vielzahl von ersten Elektroden über ihre zweite Endfläche (ex2) mit dem Verbindungselement (C) in Kontakt steht und jede erste Elektrode (E1) über ihre zweite Endfläche (ex2) nur mit höchstens einem Verbindungselement (C) in Kontakt steht;
> - einen Schritt (203) zum Aufbringen einer Schicht aus aktivem Material (A), bei jedem Verbindungselement (C), auf den Kontakt der ersten Endfläche (ex1) mindestens einer ersten Elektrode (E1), die in direktem Kontakt mit dem Verbindungselement (C) steht;
> - einen Schritt (204) zum Erzeugen mindestens einer zweiten Elektrode (E2) auf der Schicht aus aktivem Material (A), sodass bei jedem Verbindungselement (C) die zweite Elektrode (E2) mit mindestens einer ersten Elektrode (E1) ausgerichtet ist, die in direktem Kontakt mit dem Verbindungselement (C) steht, und die zweite Elektrode (E2) von der mindestens einen ersten Elektrode (E1) durch die Schicht aus aktivem Material (A) getrennt ist.

**2.** Verfahren (200) nach dem vorstehenden Anspruch, **dadurch gekennzeichnet, dass** der Schritt (202) zum Erzeugen der Vielzahl von ersten Elektroden (E1) die folgenden Teilschritte beinhaltet:

- einen Teilschritt zum Aufbringen einer Schicht aus einem leitenden Material auf eine Schicht aus dielektrischem Material, das die Vielzahl von Verbindungselementen (C) umfasst;
- einen Teilschritt zum Aufbringen einer Harzschicht (Re) auf die Schicht aus leitendem Material;
- einen Teilschritt zum Strukturieren der Harzschicht (Re) zum Gewinnen einer Vielzahl von Harzmustern (Mo) mit dem Abstand Ep in der ersten Richtung, wobei jedes Harzmuster (Mo) eine erste Endfläche und eine zweite Endfläche mit einer Oberfläche umfasst, die größer als die Oberfläche der ersten Endfläche ist, wobei die zweite Endfläche in Kontakt mit der Schicht aus leitfähigem Material steht, wobei die zweite Endfläche die Breite Eb in der ersten Richtung aufweist;
- einen Teilschritt zum anisotropen Ätzen des Stapels, der durch die Vielzahl von Harzmustern (Mo) und die Schicht aus leitendem Material gebildet wird, mit einem Anschlag auf der Schicht aus dielektrischem Material, zum Gewinnen einer Vielzahl von ersten Elektroden (E1);
- einen Teilschritt zum Auftragen einer zweiten Schicht aus einem dielektrischen Material, sodass die Vielzahl der ersten Elektroden (E1) bedeckt ist;
- einen Teilschritt zum teilweisen Entfernen der zweiten Schicht aus dielektrischem Material, sodass die erste Endfläche (ex1) jeder ersten Elektrode (E1) freigelegt wird.

3. Verfahren (200) nach dem einem der Ansprüche 1 bis 2, **dadurch gekennzeichnet, dass** der Schritt (202) zum Erzeugen der Vielzahl von ersten Elektroden (E1) die folgenden Teilschritte beinhaltet:

- einen Teilschritt zum Aufbringen einer Schicht aus einem leitenden Material auf eine Schicht aus dielektrischem Material, das die Vielzahl von Verbindungselementen (C) umfasst;
- einen Teilschritt zum Erzeugen einer Vielzahl von Masken (Ma) mit dem Abstand Ep in der ersten Richtung auf der Schicht aus leitendem Material, wobei jede Maske (Ma) in der ersten Richtung eine Breite aufweist, die mindestens gleich der Breite Eb ist;
- einen Teilschritt zum isotropen Ätzen zum Gewinnen der Vielzahl von ersten Elektroden (E1);
- einen Teilschritt zum Entfernen der Vielzahl von Masken (Ma);
- einen Teilschritt zum Aufbringen einer zweiten Schicht aus einem dielektrischen Material, sodass die Vielzahl von ersten Elektroden (E1) bedeckt ist;

- einen Teilschritt zum teilweisen Entfernen der zweiten Schicht aus dielektrischem Material, sodass die erste Endfläche (ex1) jeder ersten Elektrode freigelegt wird.

4. Verfahren nach einem der Ansprüche 2 oder 3, **dadurch gekennzeichnet, dass** der Teilschritt zum teilweisen Entfernen durch ein mechanisch-chemisches Polierverfahren erfolgt.

5. Verfahren nach dem vorstehenden Anspruch, **dadurch gekennzeichnet, dass** zuvor in dem leitenden Material zusätzlich zu der Vielzahl von ersten Elektroden mindestens eine Unterlegscheibe (20) erzeugt worden ist, wobei die Unterlegscheibe (20) eine in senkrechter Richtung zur Bezugsebene (R) gemessene Höhe aufweist, die im Wesentlichen gleich der Höhe jeder ersten Elektrode (E1) ist, und eine erste Endfläche (21) aufweist, die größer ist als die erste Endfläche (ex1) jeder ersten Elektrode (E1), sodass sie beim mechanisch-chemischen Polieren eine Anschlagfläche bildet.

6. Verfahren nach einem der Ansprüche 4 oder 5, **dadurch gekennzeichnet, dass** der Teilschritt zum teilweisen Entfernen Folgendes umfasst:

- einen ersten Teilschritt zum mechanisch-chemischen Polieren, das nicht bis zu der ersten Endfläche (ex1) jeder ersten Elektrode (E1) reicht, und
- einen zweiten Teilschritt zum Ätzen, um die erste Endfläche (ex1) jeder ersten Elektrode (E1) freizulegen.

7. Vielzahl von resistiven Speichern, die durch ein Herstellungsverfahren nach einem der vorstehenden Ansprüche gewonnen werden können, wobei jeder resistive Speicher eine erste Elektrode (E1) und eine zweite Elektrode (E2) umfasst, die durch eine Schicht aus aktivem Material (A) getrennt sind, wobei die Vielzahl von resistiven Speichern Folgendes umfasst:

- Vielzahl von Verbindungselementen (C), die sich im Wesentlichen entlang einer Bezugsebene (R) mit einem Abstand Cp in einer ersten Richtung parallel zu der Bezugsebene R erstreckt, wobei jedes Verbindungselement (C) eine Breite Cb, gemessen in der ersten Richtung, aufweist;
- Vielzahl von ersten Elektroden (E1) mit einem Abstand Ep in der ersten Richtung, wobei jede erste Elektrode (E1) eine erste Endfläche (ex1) und eine zweite Endfläche (ex2) aufweist, wobei die zweite Endfläche eine Breite Eb, gemessen in der ersten Richtung, und eine Oberfläche aufweist, die größer ist als die Oberfläche der ersten Endfläche (ex1);

wobei die Vielzahl von resistiven Speichern **dadurch gekennzeichnet ist, dass** jedes Verbindungselement (C) in direktem Kontakt mit mindestens einer ersten Elektrode (E1) steht und dass mindestens eine erste Elektrode (E1) mit keinem Verbindungselement (C) in direktem Kontakt steht.

8. Vielzahl von resistiven Speichern, die durch ein Herstellungsverfahren nach einem der Ansprüche 1 bis 6 gewonnen werden können, wobei jeder Speicher der Vielzahl von resistiven Speichern eine erste Elektrode (E1) und eine zweite Elektrode (E2) umfasst, die durch eine Schicht aus aktivem Material (A) getrennt sind, wobei die Vielzahl von resistiven Speichern Folgendes umfasst:

   - Vielzahl von Verbindungselementen (C), die sich im Wesentlichen entlang einer Bezugsebene (R) mit einem Abstand Cp in einer ersten Richtung parallel zu der Bezugsebene R erstreckt, wobei jedes Verbindungselement (C) eine Breite Cb, gemessen in der ersten Richtung, aufweist;
   - Vielzahl von ersten Elektroden (E1) mit einem Abstand Ep in der ersten Richtung, wobei jede erste Elektrode (E1) eine erste Endfläche (ex1) und eine zweite Endfläche (ex2) aufweist, wobei die zweite Endfläche eine Breite Eb, gemessen in der ersten Richtung, und eine Oberfläche aufweist, die größer ist als die Oberfläche der ersten Endfläche (ex1);

   wobei die Vielzahl von resistiven Speichern **dadurch gekennzeichnet ist, dass** jedes Verbindungselement (C) in direktem Kontakt mit mindestens einer ersten Elektrode (E1) steht und dass mindestens ein Verbindungselement (C) in direktem Kontakt mit mehreren ersten Elektroden (E1) steht.

9. Vielzahl von resistiven Speichern, die durch ein Herstellungsverfahren nach einem der Ansprüche 1 bis 6 gewonnen werden können, wobei jeder Speicher der Vielzahl von resistiven Speichern eine erste Elektrode (E1) und eine zweite Elektrode (E2) umfasst, die durch eine Schicht aus aktivem Material (A) getrennt sind, wobei die Vielzahl von resistiven Speichern Folgendes umfasst:

   - Vielzahl von Verbindungselementen (C), die sich im Wesentlichen entlang einer Bezugsebene (R) mit einem Abstand Cp in einer ersten Richtung parallel zu der Bezugsebene R erstreckt, wobei jedes Verbindungselement (C) eine Breite Cb, gemessen in der ersten Richtung, aufweist;
   - Vielzahl von ersten Elektroden (E1) mit einem Abstand Ep in der ersten Richtung, wobei jede erste Elektrode (E1) eine erste Endfläche (ex1) und eine zweite Endfläche (ex2) aufweist, wobei die zweite Endfläche eine Breite Eb, gemessen in der ersten Richtung, und eine Oberfläche aufweist, die größer ist als die Oberfläche der ersten Endfläche (ex1);

wobei die Vielzahl von resistiven Speichern **dadurch gekennzeichnet ist, dass**:

   - jedes Verbindungselement (C) in direktem Kontakt mit mindestens einer ersten Elektrode (E1) steht,
   - mindestens eine erste Elektrode (E1) mit keinem Verbindungselement (C) in direktem Kontakt steht und
   - mindestens ein Verbindungselement (C) in direktem Kontakt mit mehreren ersten Elektroden (E1) steht.

## Claims

1. Method (200) for manufacturing a plurality of resistive random access memories, each resistive random access memory comprising a first electrode (E1) and a second electrode (E2) separated by a layer of active material (A), each resistive random access memory being initially in an insulating state and going from the insulating state to a conductive state by the application of a threshold voltage VFORMING between the first and second electrodes (E1, E2), the method for manufacturing comprising:

   - a step (201) of producing a plurality of connector elements (C) extending substantially along a reference plane (R) with a step Cp along a first direction parallel to the reference plane (R), each connector element having a width Cb measured along the first direction;
   - a step (202) of producing a plurality of first electrodes (E1) on the plurality of connector elements (C), without any alignment constraint between the plurality of connector elements (C) and the plurality of first electrodes (E1), the plurality of first electrodes (E1) having a step Ep along the first direction, each first electrode (E1) having a first end surface (ex1) and a second end surface (ex2), the second end surface (ex2) having a width Eb measured along the first direction and an area greater than the area of the first end surface (ex1); the step Ep and the width Eb being such that:

$$0 < Ep - Eb \leq Cp - Cb$$

$$0 < Ep < Cb$$

and:

$$Eb < Cp - Cb$$

such that, for each connector element (C) of the plurality of connector elements, at least one first electrode (E1) of the plurality of first electrodes is in contact, via its second end surface (ex2), with said connector element (C), and each first electrode (E1) is only in contact, via its second end surface (ex2), with at the most one connector element (C);
- a step (203) of deposition of a layer of active material (A) in contact, for each connector element (C), with the first end surface (ex1) of at least one first electrode (E1) in direct contact with said connector element (C);
- a step (204) of producing, on the layer of active material (A), at least one second electrode (E2) in such a way that for each connector element (C), the second electrode (E2) is aligned with at least one first electrode (E1) in direct contact with said connector element (C), and the second electrode is separated from said at least one first electrode (E1) by the layer of active material (A).

2. Method (200) according to the preceding claim **characterised in that** step (202) of producing the plurality of first electrodes (E1) comprises the following sub-steps:

   - a sub-step of deposition, on a layer of dielectric material comprising the plurality of connector elements (C), of a layer of a conductive material;
   - a sub-step of deposition, on the layer of the conductive material, of a resin layer (Re);
   - a sub-step of structuring the resin layer (Re) to obtain a plurality of resin patterns (Mo) with the step Ep along the first direction, each resin pattern (Mo) comprising a first end surface and a second end surface having an area greater than the area of the first end surface, the second end surface being in contact with the layer of conductive material, the second end surface having the width Eb along the first direction;
   - a sub-step of anisotropic etching of the stack formed by the plurality of resin patterns (Mo) and the layer of conductive material, with stoppage on the layer of dielectric material, to obtain the plurality of first electrodes (E1);
   - a sub-step of deposition of a second layer of a dielectric material in such a way as to cover the plurality of first electrodes (E1);

   - a sub-step of partial removal of the second layer of dielectric material in such a way as to release the first end surface (ex1) of each first electrode (E1).

3. Method (200) according to any of claims 1 to 2 **characterised in that** step (202) of producing the plurality of first electrodes (E1) comprises the following sub-steps:

   - a sub-step of deposition, on a layer of dielectric material comprising the plurality of connector elements (C), of a layer of a conductive material;
   - a sub-step of producing, on the layer of conductive material, a plurality of masks (Ma) with the step Ep along the first direction, each mask (Ma) having a width along the first direction at least equal to the width Eb;
   - a sub-step of isotropic etching to obtain the plurality of first electrodes (E1);
   - a sub-step of removal of the plurality of masks (Ma);
   - a sub-step of deposition of a second layer of a dielectric material in such a way as to cover the plurality of first electrodes (E1);
   - a sub-step of partial removal of the second layer of dielectric material in such a way as to release the first end surface (ex1) of each first electrode (E1).

4. Method according to any of claims 2 or 3 **characterised in that** the sub-step of partial removal is carried out by a chemical mechanical polishing technique.

5. Method according to the preceding claim, **characterised in that** at least one dummy (20) has been produced beforehand in the conductive material in addition to the plurality of first electrodes, the dummy (20) having a height, measured along a direction perpendicular to the reference plane (R), substantially equal to the height of each first electrode (E1) and having a first end surface (21) larger than the first end surface (ex1) of each first electrode (E1) in such a way as to form a stop surface during a chemical mechanical polishing.

6. Method according to any of claims 4 or 5 **characterised in that** the sub-step of partial removal comprises:

   - a first sub-step of chemical mechanical polishing not emerging on the first end surface (ex1) of each first electrode (E1), and
   - a second sub-step of etching in order to free the first end surface (ex1) of each first electrode (E1).

7. Plurality of resistive random access memories obtainable by a method for manufacturing according to any of the preceding claims, each memory of the plurality of resistive random access memories comprising a first electrode (E1) and a second electrode (E2) separated by a layer of active material (A), the plurality of resistive random access memories comprising:

- a plurality of connector elements (C) extending substantially along a reference plane (R) with a step Cp along a first direction parallel to the reference plane, each connector element (C) having a width Cb measured along the first direction;
- a plurality of first electrodes (E1) with a step Ep along the first direction, each first electrode (E1) having a first end surface (ex1) and a second end surface (ex2), the second end surface having a width Eb measured along the first direction and an area greater than the area of the first end surface (ex1);

the plurality of resistive random access memories being **characterised in that** each connector element (C) is in direct contact with at least one first electrode (E1) and **in that** at least one first electrode (E1) is not in direct contact with any connector element (C).

8. Plurality of resistive random access memories obtainable by a method for manufacturing according to any of claims 1 to 6, each memory of the plurality of resistive random access memories comprising a first electrode (E1) and a second electrode (E2) separated by a layer of active material (A), the plurality of resistive random access memories comprising:

- a plurality of connector elements (C) extending substantially along a reference plane (R) with a step Cp along a first direction parallel to the reference plane, each connector element (C) having a width Cb measured along the first direction;
- a plurality of first electrodes (E1) with a step Ep along the first direction, each first electrode (E1) having a first end surface (ex1) and a second end surface (ex2), the second end surface having a width Eb measured along the first direction and an area greater than the area of the first end surface (ex1);

the plurality of resistive random access memories being **characterised in that** each connector element (C) is in direct contact with at least one first electrode (E1) and **in that** at least one connector element (C) is in direct contact with several first electrodes (E1).

9. Plurality of resistive random access memories obtainable by a method for manufacturing according to any of claims 1 to 6, each memory of the plurality of resistive random access memories comprising a first electrode (E1) and a second electrode (E2) separated by a layer of active material (A), the plurality of resistive random access memories comprising:

- a plurality of connector elements (C) extending substantially along a reference plane (R) with a step Cp along a first direction parallel to the reference plane, each connector element (C) having a width Cb measured along the first direction;
- a plurality of first electrodes (E1) with a step Ep along the first direction, each first electrode (E1) having a first end surface (ex1) and a second end surface (ex2), the second end surface having a width Eb measured along the first direction and an area greater than the area of the first end surface (ex1);

the plurality of resistive random access memories being **characterised in that**:

- each connector element (C) is in direct contact with at least one first electrode (E1),
- at least one first electrode (E1) is not in direct contact with any connector element (C), and
- at least one connector element (C) is in direct contact with several first electrodes (E1).

**Fig. 1**

**Fig. 2**

Fig. 3a

Ep

E2

A

E1 · · · E1 · · · E1 · · · E1 · · · E1

C · · · Eb · · · C · · · C · · · C

Cp

Cb

Fig. 3b

Ep · · · Eb

E2

A

E1

E1 · · · E1 · · · E1 · · · E1

C · · · C · · · C · · · C

Cp

Cb

Fig. 4a

Fig. 4b

Fig. 4c

Fig. 4d

Fig. 4e

**Fig. 5a**

Re

C

**Fig. 5b**

Mo

C

**Fig. 5c**

E1

C

**Fig. 5d**

E1

C

**Fig. 6a**

**Fig. 6b**

**Fig. 6c**

**Fig. 6d**

**Fig. 7**

**Fig. 8a**

**Fig. 8b**

**Fig. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010084741 A
- US 2015236256 A
- US 2009261313 A